Europäisches Patentamt

European Patent Office

Office européen des brevets

(19)

(11) EP 1 123 993 A2

(12) **EUROPEAN PATENT APPLICATION**

(43) Date of publication:
**16.08.2001 Bulletin 2001/33**

(51) Int Cl.7: **C30B 29/36**, C30B 33/00

(21) Application number: **01102504.6**

(22) Date of filing: **05.02.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **08.02.2000 JP 2000030763**

(71) Applicant: **Nippon Pillar Packing Co., Ltd.
Osaka-shi, Osaka (JP)**

(72) Inventors:
• **Tanino, Kichiya, Nippon Pillar Packing Co., Ltd.
Sanda-shi, Hyogo (JP)**
• **Tanishita, Yasutsugu,
Nippon Pillar Pack. Co., Ltd
Sanda-shi, Hyogo (JP)**

(74) Representative: **Fleuchaus, Leo, Dipl.-Ing. et al
Patentanwälte
Schroeter-Fleuchaus- Lehmann & Gallo,
Melchiorstrasse 42
81479 München (DE)**

(54) **Single crystal SiC and method of growing the same**

(57)     In the single crystal SiC according to the invention, heat treatment is performed in an inert gas atmosphere under a state where a cutting plane of a single crystal $\alpha$-SiC substrate which is produced in a plate-like form by cutting along (1 1 $\bar{2}$ 0) Miller index plane $\pm$ 10°, and (2 2 0) Miller index plane of a polycrystalline $\beta$-SiC plate are superimposed on each other, whereby single crystal having a crystal orientation of an orientation of the cutting plane is integrally grown in the polycrystalline $\beta$-SiC plate in conformity with the single crystal $\alpha$-SiC substrate. According to this configuration, single crystal SiC of very high quality is obtained to which influence of micropipes of the single crystal $\alpha$-SiC substrate is not transferred, thereby preventing distortion and micropipe defects from occurring.

Fig.1

EP 1 123 993 A2

## Description

Background of the Invention

1. Field of the Invention

The present invention relates to single crystal SiC and a method of growing the same, and more particularly to single crystal SiC which is used as a substrate wafer for a high temperature semiconductor electronic element such as a light-emitting diode, a rectifying element, a switching element, an amplifying element, and an optical sensor, and also to a method of growing the same.

2. Description of the Prior Art

Single crystal SiC (silicon carbide) is superior in heat resistance and mechanical strength. In addition, it is easy to perform the valence control of electrons and holes on single crystal SiC by doping an impurity. Moreover, single crystal SiC has a wide band gap (for example, single crystal 6H-SiC has a band gap of about 3.0 eV, and single crystal 4H-SiC has a band gap of 3.26 eV). For these reasons, it is possible to realize excellent high-temperature property, high-frequency property, dielectric property, and resistance to environments which cannot be attained by existing semiconductor materials such as Si (silicon) and GaAs (gallium arsenide). Therefore, single crystal SiC receives attention and is expected as a semiconductor material for a next-generation power device.

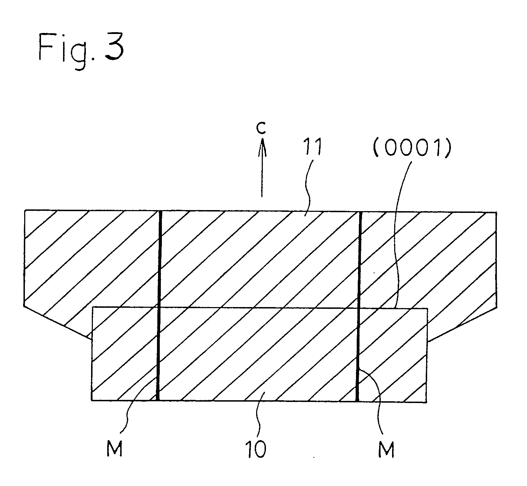

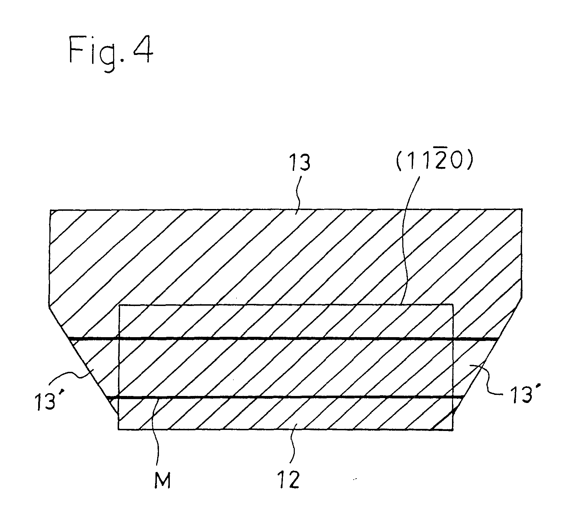

As a method of growing single crystal SiC of this type, conventionally, well known is the modified Lely method in which single crystal SiC is grown by the sublimation and recrystallization method using a seed crystal. The modified Lely method includes: a growing method which is most popularly used, and in which, as shown in Fig. 3, a single crystal a-SiC substrate 10 wherein (0 0 0 1) plane is exposed is used as a seed crystal, and single crystal SiC 11 is grown on (0 0 0 1) plane of the single crystal $\alpha$-SiC substrate 10 by vapor phase epitaxy; and another method in which, as shown in Fig. 4, a single crystal $\alpha$-SiC substrate 12 wherein a face obtained by cutting along (1 1 $\bar{2}$ 0) Miller indices is exposed is used as a seed crystal, and single crystal SiC 13 is integrally grown on the exposed cut-off face of the single crystal $\alpha$-SiC substrate 12 by vapor phase epitaxy.

In both the above-mentioned growing methods according to the modified Lely method, the crystal growth rate is as low as about 1 $\mu$m/hr., and single crystal SiC which is obtained by the sublimation and recrystallization method contains many defects and cannot sufficiently satisfy requirements in quality. In single crystal SiC which is grown by the usual modified Lely method shown in Fig. 3, particularly, micropipes M which are produced in the single crystal $\alpha$-SiC substrate 10 are transferred to the single crystal SiC 11 that is grown on the (0 0 0 1) plane of the single crystal $\alpha$-SiC substrate 10, and then grown in the c-axis direction, whereby the quality is inevitably reduced. In order to suppress such reduction of quality, it may be contemplated that the single crystal SiC 11 grown on the (0 0 0 1) plane of the single crystal $\alpha$-SiC substrate 10 is cut'along (1 1 $\bar{2}$ 0) Miller indices and then used as a wafer or the like. In this case, it is impossible to perform the cutting with an error of 0°. Moreover, not all of micropipes M elongate completely along the c-axis direction, and hence micropipes inevitably appear also in a wafer obtained by cutting, or the like.

By contrast, in the growing method based on the modified Lely method shown in Fig. 4, vapor phase bulk growth is conducted, and therefore the crystal is additionally grown not only on an exposed cut-off face of a single crystal $\alpha$-SiC substrate but also-in lateral directions of a single crystal SiC portion 13'. As a result, micropipes M which are produced in the single crystal $\alpha$-SiC substrate 12 are transferred also to the single crystal SiC portion 13' which is laterally grown. Therefore, the grown single crystal SiC 13 is inevitably formed as an incomplete crystal or a product of a low quality in which micropipe defects are produced. Consequently, single crystal SiC which is grown by any of conventional modified Lely methods is blocked from being practically used, although such single crystal SiC has many features more excellent than existing semiconductor materials such as Si and GaAs as described above.

## Summary of the Invention

The invention has been conducted in view of the above-mentioned circumstances. It is an object of the invention to provide single crystal SiC of high quality to which influence of micropipes of a single crystal substrate is not transferred and a method of growing the same, thereby preventing distortion and micropipe defects from occurring.

In order to attain the above-mentioned object, the single crystal SiC according to a first invention set forth in claim 1 is characterized in that heat treatment is performed in an inert gas atmosphere under a state where a cutting plane of a single crystal $\alpha$-SiC substrate which is formed by cutting along (1 1 $\bar{2}$ 0) Miller index plane $\pm$ 10°, and (2 2 0) Miller index plane of a polycrystalline $\beta$-SiC plate are superimposed on each other, whereby single crystal having a crystal orientation of an orientation of the cutting plane is integrally grown in the polycrystalline $\beta$-SiC plate in conformity with the single crystal $\alpha$-SiC substrate.

The method of growing single crystal SiC according to a second invention set forth in claim 3 is characterized in that, under a state where (2 2 0) Miller index plane of a polycrystalline $\beta$-SiC plate is superimposed on a cutting plane of a single crystal $\alpha$-SiC substrate which is formed by cutting along (1 1 $\bar{2}$ 0) Miller index plane $\pm$ 10°, the single crystal $\alpha$-SiC substrate and the polycrystalline β-SiC plate are heat-treated in an inert gas atmosphere, whereby single crystal having a crystal orientation of an orientation of the cutting plane is integrally grown in the polycrystalline β-SiC plate in conformity with the single crystal α-SiC substrate.

In the thus configured first and second inventions set forth in claims 1 and 3, a state where the crystal growing conditions in the interface plane are substantially uniformalized, and micropipes of the single crystal α-SiC substrate are not transferred or converted to distortion is obtained by superimposing the planes in which arrangements of Si atoms and C atoms are identical, i. e., the cutting plane along the (1 1 $\bar{2}$ 0) Miller index plane ± 10° of the single crystal α-SiC substrate, and the (2 2 0) Miller index plane of the polycrystalline β-SiC plate, and heat treatment is then conducted in an inert gas atmosphere. As a result, solid phase growth in which the whole region of the interface plane of the polycrystalline β-SiC plate is converted substantially simultaneously and rapidly to α-SiC can be performed. Therefore, it is possible to grow single crystal which is free not only micropipes but also from distortion and residual grain boundaries due to uneven crystal growth rates, so that single crystal SiC of very high quality can be obtained. Consequently, it is possible to attain an effect of expediting practical use of single crystal SiC which has excellent high-temperature property, high-frequency property, dielectric property, and resistance to environments as compared with existing semiconductor materials, and which is therefore expected as a semiconductor material for a next-generation power device.

Preferably, polycrystal which is produced in a plate-like form by the thermal chemical vapor deposition method (hereinafter, referred to as the thermal CVD method) is used as the polycrystalline β-SiC plate. In this case, since a polycrystalline β-SiC plate itself is of high purity and has no defects such as voids, grain boundaries or the like are not formed between the cutting plane of the single crystal α-SiC substrate and the (2 2 0) plane of the polycrystalline β-SiC plate, so that single crystal SiC of higher quality can be obtained.

In the method of growing single crystal SiC according to the second invention set forth in claim 3, each of at least one cutting plane of the single crystal α-SiC substrate, and at least one (2 2 0) Miller index plane of the polycrystalline β-SiC plate may be processed into a smooth mirror face of 10 angstroms RMS or less. According to this configuration, the planes can be closely contacted with each other without leaving a gap therebetween. Therefore, single crystal SiC of high quality in which residual distortion and grain boundaries are not produced in the interface plane and which is substantially free from micropipe defects can be grown and supplied efficiently and stably on an industrial scale.

Brief Description of the Drawings

Fig. 1 is a diagram showing the section structure of single crystal SiC according to a first invention;

Fig. 2 is a diagram illustrating Miller index planes of a single crystal α-SiC substrate which is used in first and second inventions;

Fig. 3 is a diagram showing the modified Lely method which, among conventional sublimation and recrystallization methods, is most popularly used for growing single crystal SiC by vapor phase epitaxy on (0 0 0 1) plane of a single crystal α-SiC substrate; and

Fig. 4 is a diagram showing the modified Lely method which, among conventional sublimation and recrystallization methods, is used for integrally growing single crystal SiC by vapor phase epitaxy on an exposed cut-off face of a single crystal α-SiC substrate wherein a face obtained by cutting along (1 1 $\bar{2}$ 0) Miller indices is exposed.

Preferred Embodiments of the Invention

Hereinafter, an embodiment of the invention will be described with reference to the drawings.

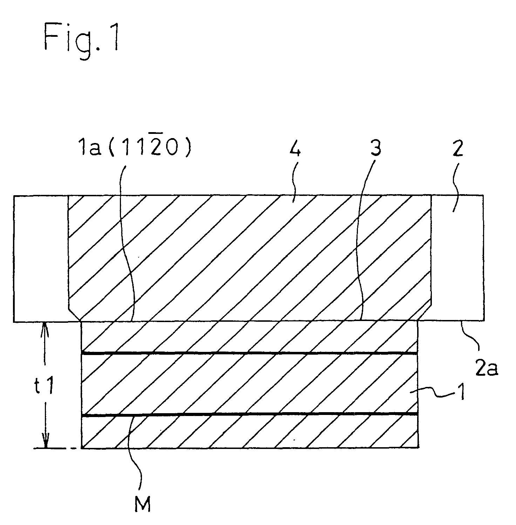

Fig. 1 is a diagram showing a state where the single crystal SiC of the invention has not yet been heat-treated, i.e., the section structure of single crystal SiC according to a first invention. In Fig. 1, 1 denotes a single crystal hexagonal α-SiC substrate (6H type). A polycrystalline β-SiC plate 2 which is produced by the thermal CVD method and which has a thickness of 1 mm is superimposed on a cutting plane la or the surface of the substrate.

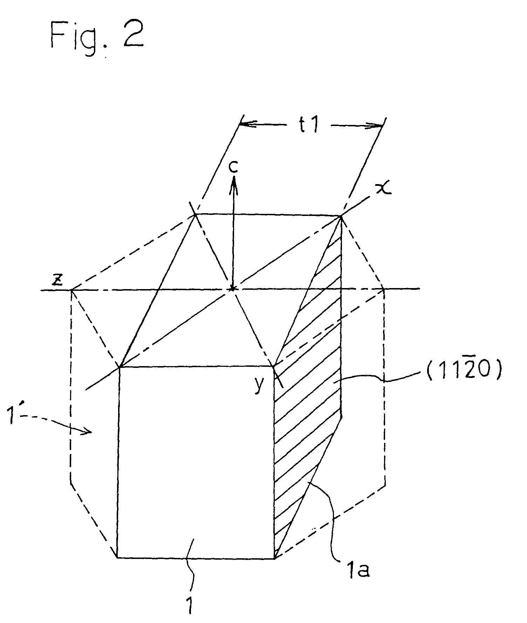

The single crystal α-SiC substrate 1 is produced in the following manner. As shown in Fig. 2, single crystal α-SiC bulk 1' which is produced by the sublimation and recrystallization method or the like is cut by a diamond cutter along (1 1 2 0) Miller index plane ± 1°, into a plate-like shape having a thickness (tl) of 0.5 mm. The front and rear faces of the cut-off single crystal α-SiC substrate 1 are polished by about 50 μm, and the one cutting plane la is processed into a smooth mirror face of 10 angstroms RMS or less.

On the other hand, (2 2 0) Miller index plane 2a of the polycrystalline β-SiC plate 2 which is produced by the thermal CVD method, and which has a thickness of 1 mm is polished, and the polished (2 2 0) plane 2a is processed into a smooth mirror face of 10 angstroms RMS or less.

Then, the cutting plane la consisting of the smooth mirror face of the single crystal α-SiC substrate 1, and the (2 2 0) Miller index plane 2a consisting of the smooth mirror face of the polycrystalline β-SiC plate 2 are superimposed on each other. The superimposed members are placed in a high-temperature electric oven using a carbon heater, and Ar gas is blown into the oven to attain an inert gas atmosphere. Under this atmosphere, the substrate 1 and the plate 2 are heated at an average rate at which the temperature is raised from 1,100°C to 2,200 ± 100°C over 30 minutes, and the temperature of 2,200 ± 100°C is maintained for one hour. As a result of this heat treatment, solid-phase growth occurs in the interface plane 3 between the cutting plane la of the single crystal a-SiC substrate 1 and the (2 2 0) Miller index plane 2a of the polycrystalline β-SiC plate 2, so that a single crystal portion 4 which has the crystal orientation of the orientation of the cutting plane la in conformity with the single crystal a-SiC substrate 1, and which is approximately colorless and transparent is grown integrally in the polycrystalline β-SiC plate 2 and over the whole region of the interface plane 3.

The inventors conducted crystal X-ray analysis using an X-ray diffractometer on samples of the single crystal SiC which were grown in the manner described above. As a result, it was confirmed that the single crystal portion 4 grown in the polycrystalline β-SiC plate 2 is single crystal $\alpha$-(6H)-SiC which has the crystal orientation of the orientation of (1 1 $\bar{2}$ 0) in conformity with the single crystal $\alpha$-SiC substrate 1.

Moreover, samples of the single crystal SiC were observed by a polarization microscope. As a result, it was confirmed that no micropipes M are produced in the single crystal portion 4 grown in the polycrystalline β-SiC plate 2. Evenness of crystal was shown from observation by a Lang camera. Therefore, it was confirmed that the samples were single crystal SiC of high quality.

Alternatively, a thin layer configured by $SiO_2$ (silica), Si, or a mixture of these materials may be interposed in the superimposed portion of the cutting plane la of the single crystal $\alpha$-SiC substrate 1 and the (2 2 0) Miller index plane 2a of the polycrystalline β-SiC plate 2.

The entire disclosure of Japanese Patent Application No. 2000-030763 filed on February 8, 2000 including specification, claims, drawings, and summary are incorporated herein by reference in its entirety.

**Claims**

1. Single crystal SiC wherein
    heat treatment is performed in an inert gas atmosphere under a state where a cutting plane of a single crystal $\alpha$-SiC substrate which is formed by cutting along (1 1 $\bar{2}$ 0) Miller index plane ± 10°, and (2 2 0) Miller index plane of a polycrystalline β-SiC plate are superimposed on each other, whereby single crystal having a crystal orientation of an orientation of said cutting plane is integrally grown in said polycrystalline β-SiC plate in conformity with said single crystal $\alpha$-SiC substrate.

2. Single crystal SiC according to claim 1, wherein polycrystal which is produced in a plate-like form by a thermal chemical vapor deposition method is used as said polycrystalline β-SiC plate.

3. A method of growing single crystal SiC in which heat treatment is performed while superimposing a single crystal $\alpha$-SiC substrate and a polycrystalline β-SiC plate, wherein under a state where (2 2 0) Miller index plane of said β-SiC plate is superimposed on a cutting plane of said single crystal $\alpha$-SiC substrate which is formed by cutting along (1 1 $\bar{2}$ 0) Miller index plane ± 10°, said single crystal $\alpha$-SiC substrate and said polycrystalline β-SiC plate which are superimposed on each other are heat-treated in an inert gas atmosphere, whereby single crystal having a crystal orientation of an orientation of said cutting plane is integrally grown in said polycrystalline β-SiC plate in conformity with said single crystal $\alpha$-SiC substrate.

4. A method of growing single crystal SiC according to claim 3, wherein polycrystal which is produced in a plate-like form by a thermal chemical vapor deposition method is used as said polycrystalline β-SiC plate.

5. A method of growing single crystal SiC according to claim 3, wherein each of at least one cutting plane of said single crystal $\alpha$-SiC substrate, and at least one (2 2 0) Miller index plane of said polycrystalline β-SiC plate is processed into a smooth mirror face of 10 angstroms RMS or less.

6. A method of growing single crystal SiC according to claim 4, wherein each of at least one cutting plane of said single crystal $\alpha$-SiC substrate, and at least one (2 2 0) Miller index plane of said polycrystalline β-SiC plate which is produced in a plate-like form by the thermal chemical vapor deposition method is processed into a smooth mirror face of 10 angstroms RMS or less.

7. A method of growing single crystal SiC according to claim 3, wherein a thin layer configured by $SiO_2$, Si, or a mixture of these materials is interposed in a superimposed portion of said cutting plane of said single crystal $\alpha$-SiC substrate and said (2 2 0) Miller index plane of said polycrystalline β-SiC plate.

8. A method of growing single crystal SiC according to claim 4, wherein a thin layer configured by $SiO_2$, Si, or a mixture of these materials is interposed in a superimposed portion of said cutting plane of said single crystal $\alpha$-SiC substrate and (2 2 0) Miller index plane of said polycrystalline β-SiC plate which is produced in a plate-like form by the thermal chemical vapor deposition method.

9. A method of growing single crystal SiC according to claim 3, wherein a temperature of said heat treatment is set to be in a range of 2,100 to 2,300°C.

**10.** A method of growing single crystal SiC according to claim 4, wherein a temperature of said heat treatment is set to be in a range of 2,100 to 2,300°C.

Fig.1

Fig. 2

Fig. 3

Fig.4